# EUROPÄISCHE PATENTSCHRIFT

(11) **EP 1 537 528 B1**
(45) Veröffentlichungstag und Bekanntmachung des Hinweises auf die Patenterteilung: **07.06.2006**
(21) Anmeldenummer: 03794951.8
(22) Anmeldetag: 27.08.2003
(51) Int. Cl.: G06K 19/077

(54) **TRAGBARER DATENTRÄGER MIT ANZEIGEVORRICHTUNG**
PORTABLE DATA CARRIER WITH A DISPLAY DEVICE
SUPPORT DE DONNEES PORTABLE AVEC DISPOSITIF D'AFFICHAGE

(30) Priorität: 28.08.2002 DE 10239564
(43) Veröffentlichungstag der Anmeldung: 08.06.2005
(73) Patentinhaber: Giesecke & Devrient GmbH, 81677 München (DE)
(72) Erfinder: KLUGE, Stefan, 80997 München (DE)
(74) Vertreter: Klunker . Schmitt-Nilson . Hirsch
(86) Internationale Anmeldenummer: PCT/EP2003/009500
(87) Internationale Veröffentlichungsnummer: WO 2004/025552

(56) Entgegenhaltungen:
- DE-A- 19 954 841
- DE-C- 19 963 165
- US-A- 4 795 895
- US-A- 4 876 441
- US-A1- 2002 020 491

## Beschreibung

Die Erfindung betrifft ein Verfahren zur Herstellung eines tragbaren, kartenförmigen, elektronischen Datenträgers, insbesondere einer Chipkarte, Kreditkarte, Scheckkarte, Geldkarte und dergleichen, mit einem Display, das Licht in bestimmten Bereichen reflektiert, und mit einem Kartenkörper mit einer Aussparung, in der das Display aufgenommen ist. Weiter betrifft die Erfindung einen entsprechenden tragbaren Datenträger, insbesondere eine Chipkarte.

Das Display einer Chipkarte wird zumeist als vorgefertigte Einheit während der Produktion in eine vorbereitete Aussparung in der Chipkarte eingesetzt, um den Herstellungsaufwand bei der Chipkartenfertigung gering zu halten. Ein vorgefertigtes reflektives Display, das heißt ein Display, dessen Darstellungsfunktion durch Reflexion/ Absorption von einfallendem Licht erreicht wird, weist an der Unterseite einer Substratträgerschicht eine Reflexionsschicht auf und auf der Oberseite der Substratträgerschicht zwischen zwei Leiterbahnschichten eine Flüssigkristallschicht. Die außenliegende Leiterbahnschicht des vorgefertigten Displays ist wiederum von einer transparenten Deckschicht abgedeckt. Das in die Aussparung eingesetzte Display wird anschließend an von oben in die Aussparung hineinragende Leiterbahnenden kontaktiert. Schließlich wird über das in die Aussparung eingesetzte, kontaktierte Display eine Deckfolie gezogen, um die Kontaktierungsstelle zu verdecken.

Aus der US 4,876,441 A1 ist eine Kreditkarte mit einem Taschenrechner entnehmbar, der über ein Display verfügt. Das Display wird dabei als separate Einheit bereitgestellt und beim Einbau mit im Kartenkörper liegenden Gegenkontakten verbunden. Das Display wird zwischen eine Trägerschicht und eine Deckschicht eingebaut.

Displays und ihre Einbaumöglichkeiten sind in vielen Schriften beschrieben. So ist aus der DE 199 54 841 A1 eine Gerätefronteinheit bekannt, in die eine Flüssigkristallanzeigevorrichtung eingebracht ist, deren Kontaktierung von einer Unterseite erfolgt. Aus der DE 199 63165 C1 ist weiter eine Chipkarte mit einer Flüssigkristallanzeige bekannt, wobei zur Erhöhung der Bruchsicherheit mindestens eine der mit der Anzeige verbundenen Trägerschichten als Glaskunststoffverbund ausgebildet ist. Aus der US 4,795,895 A1 und der US 2002/0020491 A1 ist jeweils der Vorschlag entnehmbar, zur Erzeugung von elektrischen Verbindungen bei der Herstellung von Chipkarten anisotrop elektrisch leitende Klebstoffe einzusetzen.

Eine grundsätzliche Schwierigkeit im Hinblick auf gegenwärtig zur Verfügung stehende Flachdisplays ist, daß diese empfindlich sind gegenüber Temperaturbelastungen, wie sie insbesondere beim Laminieren auftreten, wenn etwa Schichten aus thermoplastischen Kunststoffen unter Druck und Temperatur miteinander verbunden werden.

Es ist deshalb erforderlich, die Produktionsverfahren entsprechend so auszulegen, daß Belastungen nicht oder nur im geringsten möglichen Maße auftreten. Unvermeidlich steigen dadurch die Produktionskosten an, da aufwendigere Maschinen und Vorrichtungen zur Fertigung der Karten benutzt werden müssen. Die Ausschußrate während des Herstellungsverfahrens einer solchen Karte steigt an.

Es ist daher erwünscht, das Display zu einem möglichst späten Zeitpunkt des Herstellungsverfahrens in die Karte einzusetzen. Bei einem reflektiven Display befindet sich jedoch immer auf der Unterseite des Displays die Reflexionsschicht, die zumeist aus aufgedampftem Metall besteht, während sich die Anschlußkontakte für das Display auf der von der Reflexionsschicht abgewandten Oberseite des Displays befinden, um herstellungsbedingte, durch die Reflexionsschicht verursachte Kurzschlüsse zwischen den Anschlußkontakten zu vermeiden. Aufgrund dieses Aufbaus ist es nicht möglich, ein derartiges Display in einem sehr späten Schritt des Herstellungsverfahrens in die Karte einzusetzen, weil zumindest noch die zur Kartenoberfläche weisenden Kontakte kontaktiert und die Kontaktstellen mit einer Deckfolie abgedeckt werden müssen.

Es ist daher Aufgabe der vorliegenden Erfindung, ein Verfahren zur Herstellung eines tragbaren Datenträgers, insbesondere einer Chipkarte, mit reflektivem Display zur Verfügung zu stellen, bei dem das Display in einem letzten Verfahrensschritt montierbar ist.

Diese Aufgabe wird durch einen tragbaren Datenträger und ein Verfahren zu dessen Herstellung gemäß den unabhängigen Ansprüchen gelöst. In den Unteransprüchen sind vorteilhafte Weiterbildungen und Ausgestaltungen der Erfindung angegeben.

Erfindungsgemäß ist vorgesehen, daß die Aussparung, in die das Display eingesetzt wird, auf ihrer Grundfläche zunächst mit einer Reflexionsschicht ausgestattet wird. Dies kann vorteilhaft durch Einlegen eines durch Aufbringen einer Reflexionsschicht auf ein Reflektorsubstrat vorgefertigten Reflektors geschehen. Das Display selbst wird währenddessen in an sich üblicher Weise, jedoch ohne Reflexionsschicht vorgefertigt. Das so vorgefertigte Display wird sodann in die Aussparung eingesetzt, wobei die Kontaktflächen des Displays zur Aussparung gerichtet sind und an Gegenkontaktflächen der Aussparung anliegen.

Da die Kontaktflächen des Displays nicht zur Kartenaußenseite zeigen, sondern direkt nach dem Einsetzen in die Aussparung mit den Gegenkontaktflächen der Aussparung in Kontakt kommen, kann das Display in einem letzten Arbeitsschritt eingesetzt werden. Auf die geringere Belastbarkeit des Displays gegenüber Temperaturen sowie Druck und Verbiegungen muß daher bei der Herstellung eines tragbaren Datenträgers bis zu diesem Zeitpunkt keine Rücksicht genommen werden. Insbesondere ist es nicht erforderlich, eine zusätzliche Kartendeckschicht aufzubringen, um etwaige Kontaktierungsstellen zu verdecken. Indem zur Realisierung des erfindungsgemäßen Verfahrens im wesentlichen herkömmliche, kostengünstige Herstellungstechniken einsetzbar sind, wird die Herstellung insgesamt verbilligt.

In einer bevorzugten Ausführungsform sind die Gegenkontaktflächen auf einer zwischen Kartenoberseite und Grundfläche angeordneten Abstufung ausgebildet, und das Display weist eine entsprechende Abstufung mit daran ausgebildeten Gegenkontaktflächen auf. Die Gegenkontaktflächen und die Reflexionsschicht auf der Grundfläche der Aussparung liegen somit auf verschiedenen Ebenen, wodurch die Anforderungen an die Positionierungsgenauigkeit beim Aufbringen der Reflexionsschicht herabgesetzt werden. Das wiederum vermindert die Gefahr, daß es zu Kurzschlüssen zwischen der Reflexionsschicht und den Gegenkontaktflächen kommt. Die Kontaktflächen des Displays können dann auch in herkömmlicher Art auf einem über die Flüssigkristallschicht hervorragenden Teil des Display-Trägersubstrats liegen und als Bestandteil der ITO-Displayleiterbahnen ausgebildet sein.

Vorteilhaft werden die Kontaktflächen und Gegenkontaktflächen mittels eines anisotrop elektrisch leitfähigen Klebers kontaktiert, um Querströme zu verhindern, die zum Kurzschluß zwischen den Kontakten führen könnten. Das Display ist somit gleichzeitig in der Aussparung fixiert.

In einer günstigen Ausführungsform schließt das Display bündig mit der Kartenoberseite ab, ohne daß es weiterer Deckschichten bedarf.

Ein besonderer Vorteil der Erfindung ist darin zu sehen, daß zu ihrer Umsetzung übliche Displays mit einem herkömmlichen Schichtaufbau verwendet werden können, die lediglich eine aufgedampfte Reflexionsschicht - die stattdessen separat auf die Grundfläche der Aussparung aufgebracht wird - nicht aufweisen und die im übrigen umgekehrt zu der sonst üblichen Einbaurichtung in die Aussparung eingesetzt werden, so daß die ursprünglich als innenliegende Substratschicht gedachte Schicht zur Deckschicht wird.

Besteht die Möglichkeit, das Display selbst zu bearbeiten, so kann in einer vorteilhaften Abwandlung des erfindungsgemäßen Verfahrens vorgesehen sein, die Reflexionsschicht auf der üblicherweise die Oberseite bildenden Oberfläche der Displays aufzubringen, bevor das Display in den vorbereiteten Kartenkörper eingesetzt wird.

Nachfolgend wird die Erfindung anhand eines Ausführungsbeispieles unter Bezugnahme auf die beigefügten Zeichnungen näher beschrieben. Es zeigen:
- Figur 1: einen Detailausschnitt eines tragbaren Datenträgers mit Display im Querschnitt,
- Fig. 2 bis 5: einen Datenträger nach Figur 1 in verschiedenen Stadien des Herstellungsverfahrens,
- Figur 6: ein reflektives Display gemäß dem Stand der Technik im Querschnitt, und
- Figur 7: einen Detailausschnitt eines tragbaren Datenträgers mit Display gemäß dem Stand der Technik im Querschnitt.

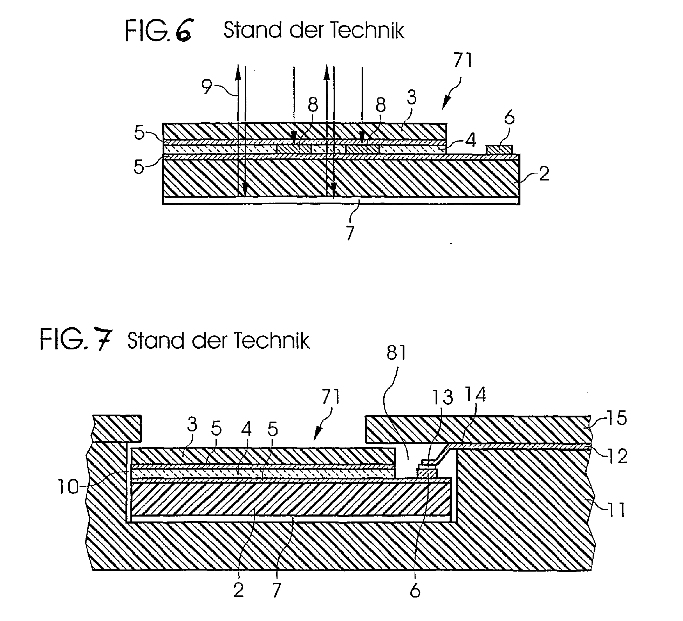

Figur 6 zeigt zunächst schematisch im Querschnitt ein sogenanntes "reflektives" Display 71, d.h. ein Display, das Licht in bestimmten Bereichen reflektiert, gemäß dem Stand der Technik. Das Display 71 ist aufgebaut aus einem unteren Trägersubstrat 2, einem oberen Trägersubstrat 3 und einer zwischen diesen angeordneten Flüssigkristallschicht 4. Oberhalb sowie unterhalb der Flüssigkristallschicht 4 sind semitransparente ITO-Leiterbahnschichten 5 angeordnet. In einem über die Flüssigkristallschicht 4 seitlich herausragenden Bereich des unteren Trägersubstrats 2 sind auf der Leiterbahnschicht 5 Kontaktflächen 6 angeordnet, die ebenfalls beispielsweise aus ITO bestehen können. Auf der der Flüssigkristallschicht 4 abgewandten Seite der unteren Trägersubstratschicht 2 ist eine Reflexionsschicht 7 aufgebracht.

Durch Anlegen und Nichtanlegen von Spannung an einzelne Ansteuerbereiche 8 läßt sich die Lichtdurchlässigkeit der Flüssigkristallschicht 4 steuern. Ansteuerbereiche 8, an denen keine Spannung anliegt, sind opak und erscheinen dunkel. Ansteuerbereiche 8, an denen Spannung anliegt, ändern ihre optische Polarisierungswirkung, werden transparent und erscheinen hell. Ist eine Spannung angelegt, durchdringt von der dem Betrachter zugewandten Seite, d.h. durch das obere Trägersubstrat 3, in das Display 71 einfallendes Licht das obere Trägersubstrat 3, die Flüssigkristallschicht 4 sowie das untere Trägersubstrat 2 und wird an der Reflexionsschicht 7 reflektiert, um auf dem umgekehrten Weg seinen Rückweg zu nehmen. Liegt an der Flüssigkristallschicht 4 andererseits keine Spannung an, werden die entsprechenden Ansteuerbereiche 8 opak und unterbrechen den durch die Pfeile 9 angedeuteten optischen Weg; die Bereiche 8 erscheinen dunkel.

Figur 7 zeigt im Teilquerschnitt einen tragbaren Datenträger gemäß dem Stand der Technik mit einem Display 71 nach Figur 6. Das zweistufige Display 71 mit den Bestandteilen oberes Trägersubstrat 3, Flüssigkristallschicht 4, unteres Trägersubstrat 2, Leiterbahnschicht 5 und Reflexionsschicht 7 ist in eine Aussparung 10 eingesetzt, die in einem Kartenkörper 11 ausgefräst ist. An der Oberseite des Kartenkörpers 11 sind Leiterbahnen 12 angeordnet, die in die Aussparung 10 hineinragen und über einen leitenden Kleber 13 Verbindungen bzw. Gegenkontaktflächen 14 zu den nach außen weisenden Kontaktflächen 6 des Displays 71 bilden. Die Karte ist oberhalb der Leiterbahnen 12 mit einer separaten Deckfolie 15 überzogen. Die Deckfolie deckt gleichzeitig einen Teil der Aussparung 10 einschließlich der Kontaktierung 6,13,14 ab. Im Kontaktierungsbereich entsteht dadurch ein an sich unerwünschter Hohlraum 81, der in der Regel durch Einbringen von Füllmaterial verfüllt wird.

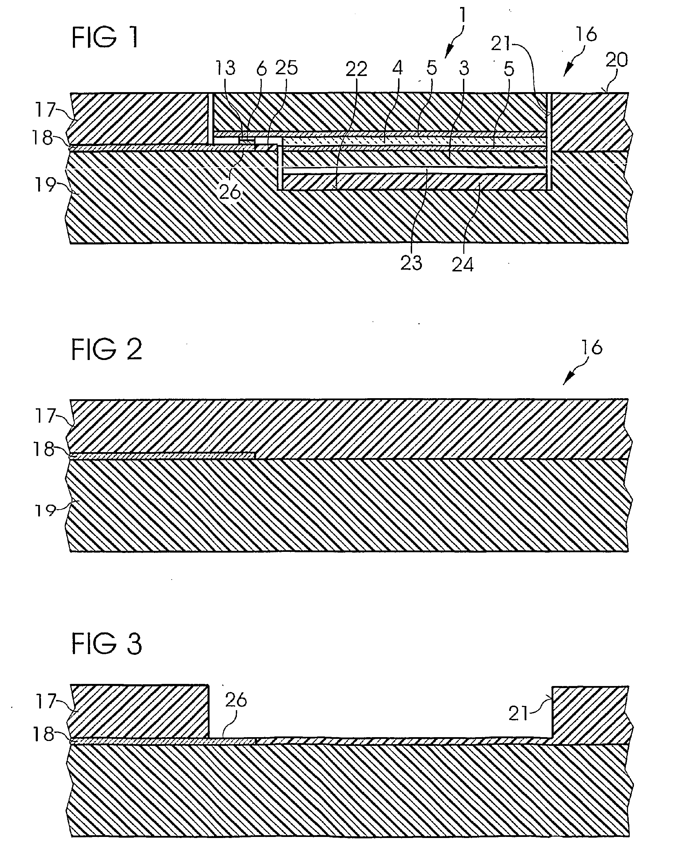

Figur 1 zeigt im Querschnitt einen Abschnitt eines erfindungsgemäßen Datenträgers 16 mit einer reflektiv arbeitenden Anzeigevorrichtung 1. Im folgenden wird davon ausgegangen, daß der Datenträger 16 die Gestalt einer Chipkarte, kurz einer Karte 16, besitzt; für die Anzeigevorrichtung 1 wird ein reflektives Display zugrundegelegt.

Das Display 1 baut sich grundsätzlich wie das in Fig. 6 gezeigte Display 71 nach dem Stand der Technik aus einer unteren Trägersubstratschicht 2, einer Flüssigkristallschicht 4 sowie einer oberen Trägersubstratschicht 3 auf. Gegenüber einem Display nach dem Stand der Technik folgen die Schichten 2, 3, 4 jedoch in umgekehrter Abfolge in Bezug auf die Einbaulage des Displays. Beidseits der Flüssigkristallschicht 4 sind wiederum die Leiterbahnschichten 5 angeordnet.

Die Karte 16 weist eine Deckschicht 17 und einen Kartenkörper 19 sowie dazwischenliegende Leiterbahnen 18 auf. In die Deckschicht 17 und den Kartenkörper 19 ist von der Kartenoberseite 20 aus eine Aussparung 21 ausgefräst. Auf deren Grundfläche 22 ist ein Reflektor, bestehend aus einer Reflexionsschicht 23 und einem Reflektorsubstrat 24, aufgebracht und mit der Grundfläche 22 fest verbunden. Im Unterschied zu dem anhand der Figuren 6 und 7 wiedergegebenen Stand der Technik ist die Reflexionsschicht 23 nun kein Bestandteil des Displays 1, sondern von diesem getrennt und wird separat in die Aussparung 21 eingebracht.

Die Aussparung 21 weist eine planparallel zur Oberseite 20 der Karte 16 angeordnete Abstufung 25 auf. In einem seitlich über die Flüssigkristallschicht 4 herausragenden Bereich des unteren Trägersubstrats 2 ist auf der Leiterbahnschicht 5 eine Kontaktfläche 6 angeordnet. Die Kontaktfläche 6 ist zum Beispiel über einen anisotrop elektrisch leitenden Kleber 13 mit einer Gegenkontaktfläche 26, die an den Leiterbahnen 18 ausgeformt ist, verbunden.

Nachfolgend wird die erfindungsgemäße Herstellung eines Datenträgers veranschaulicht. Figur 2 zeigt in einem ersten Schritt des Herstellungsverfahrens ein zur Verfügung gestelltes Halbzeug für die Karte 16, bestehend aus der Deckschicht 17, den Leiterbahnen 18 und dem Kartenkörper 19. Die Leiterbahnen 18 können als Leiterbahninlett eine separate Schicht in dem Halbzeug bilden oder auf dem Kartenkörper unmittelbar erzeugt sein. Alle Verfahrensschritte, die für ein Display ungünstige thermische oder mechanische Belastungen mit sich bringen, insbesondere Folienlaminierschritte, sind bei dem Halbzeug bereits durchgeführt.

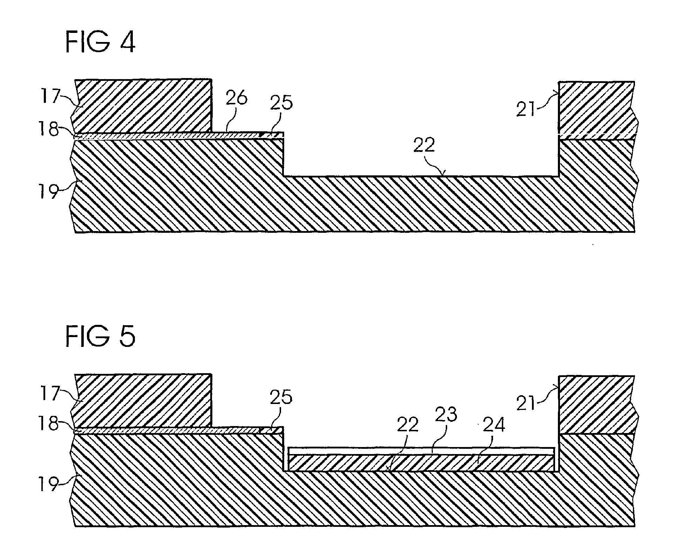

Figur 3 zeigt, im Querschnitt, das Ausfräsen einer Aussparung 21 im Bereich des später einzusetzenden Displays. Hierbei wird zunächst die Deckschicht 17 so weit abgetragen, daß im Bereich der Leiterbahnen 18 die Gegenkontaktflächen 26 freigelegt werden. Anschließend wird, wie in Figur 4 gezeigt, die Aussparung 21 weiter in den Kartenkörper 19 vertieft, bis die Grundfläche 22 der Aussparung 21 in der gewünschte Tiefe liegt. Dabei bleibt eine Abstufung 25 mit der Gegenkontaktfläche 26 auf der Höhe der ersten Frässtufe stehen. Die Schritte gemäß Figuren 3 und 4 sind auch in anderer Reihenfolge durchführbar.

Im folgenden, in Figur 5 gezeigten Verfahrensschritt wird auf die Grundfläche 22 der Aussparung 21 das Reflektorsubstrat 24 mit der Reflexionsschicht 23 aufgebracht und mit der Grundfläche 22 verbunden, z.B. verklebt. Reflexionsschicht 23 und Reflektorsubstrat 24 können dabei in der Aussparung 21 nacheinander aufgebracht oder in Form vorgefertigter Reflektoren montiert werden. Die Herstellung bzw. Montage der Reflexionsschicht 23 erfolgt also getrennt von der nachfolgend vorzunehmenden Einbringung des Displays 1, das dementsprechend selbst keine Reflexionsschicht aufweisen muß.

Sodann wird das Display 1 in die Aussparung 21 eingesetzt und werden die Kontaktflächen 6 mit den Gegenkontaktflächen 26 kontaktiert. Es entsteht ein Datenträger 16, wie er in der Figur 1 gezeigt ist, der insbesondere keine Hohlräume im Bereich des Displays 1 aufweist.

In einem nachfolgenden Herstellungsschritt können verbleibende Spalte zwischen dem Display 1 und der Aussparung 21 versiegelt werden, indem sie beispielsweise mit einem Kleber oder einem anderen geeigneten Füllmaterial gefüllt werden. Dieser Schritt kann auch zusammen mit dem vorhergehenden Schritt ausgeführt werden.

Zweckmäßig kann vorgesehen sein, daß die gesamte entstandene Karte abschließend noch mit eine Overlayfolie überzogen wird.

## Patentansprüche

1. Verfahren zur Herstellung eines tragbaren Datenträgers mit einer Anzeigevorrichtung, insbesondere einer Chipkarte mit Display, umfassend die Schritte:
- Bereitstellen eines Halbzeugs mit im Inneren angeordneten Leiterbahnen (18),
- Erzeugen einer Aussparung (21) in dem Halbzeug,
- Freilegen von Gegenkontaktflächen (26) der Leiterbahnen (18) in der Aussparung (21),
- Aufbringen einer Reflexionsschicht (23) auf die Grundfläche (22) der Aussparung (21),
- Einsetzen eines Displays (1) in die Aussparung (21), so daß das Display (1) zusammen mit der Reflexionsschicht (23) ein reflektives Display bildet, und
- Kontaktieren der Gegenkontaktflächen (26) mit Kontaktflächen (6) des Displays (1).

2. Verfahren nach Anspruch 1, **dadurch gekennzeichnet, daß** die Aussparung (21) mehrstufig ausgebildet wird, wobei die Gegenkontaktflächen (26) auf einer über der Grundfläche (22) liegenden Abstufung (25) der mehrstufigen Aussparung (21) freigelegt werden.

3. Verfahren nach Anspruch 1 oder 2, **dadurch gekennzeichnet, daß** die Kontaktflächen (6) des Displays (1) und die Gegenkontaktflächen (26) der Aussparung (21) mittels einem anisotrop elektrisch leitenden Kleber (13) kontaktiert werden.

4. Verfahren nach einem der Ansprüche 1 bis 3, **dadurch gekennzeichnet, daß** das Display (1) so in die Aussparung (21) eingesetzt wird, daß es bündig mit einer Oberfläche (20) des Halbzeugs abschließt.

5. Verfahren nach einem der Ansprüche 1 bis 4, wobei Spalte zwischen der Aussparung (21) und dem in die Aussparung eingesetzten Display (1) mit einem Füllmaterial versiegelt werden.

6. Tragbarer Datenträger mit Anzeigevorichtung, insbesondere Chipkarte mit Display, umfassend einen Kartenkörper (19) mit im Inneren der Karte angeordneten Leiterbahnen (18), einer an einer Kartenoberseite (20) liegenden Aussparung (21), in die ein Display (1) aufgenommen ist, Gegenkontaktflächen (26) in der Aussparung (21), die von den Leiterbahnen (18) gebildet werden und die an Kontaktflächen (6) des Displays (1) kontaktiert sind, wobei die Kontaktflächen (6) des Displays (1) zur Grundfläche (22) der Aussparung (21) gerichtet sind, und einer zwischen Display (1) und Grundfläche (22) der Aussparung (21) angeordneten Reflexionsschicht (23), **dadurch gekennzeichnet daß** die Reflexionsschicht (23) vor Einsetzen des Displays (1) in die Aussparung (21) auf die Grundfläche (22) der Aussparung (21) aufgebracht wurde und fest mit dieser verbunden ist.

7. Datenträger nach Anspruch 6, **dadurch gekennzeichnet, daß** die Aussparung (21) mehrstufig ausgebildet ist, wobei die Gegenkontaktflächen (26) auf einer zwischen Kartenoberseite (20) und Grundfläche (22) angeordneten Abstufung (25) der mehrstufigen Aussparung (21) ausgebildet sind und das Display (1) eine entsprechende Abstufung mit den daran ausgebildeten Kontaktflächen (6) aufweist.

8. Datenträger nach einem der Ansprüche 6 oder 7, **dadurch gekennzeichnet, daß** die Kontaktflächen (6) und Gegenkontaktflächen (26) mit einem anisotrop elektrisch leitenden Kleber (13) verbunden sind.

9. Datenträger nach einem der Ansprüche 6 bis 8, **dadurch gekennzeichnet, daß** das Display (1) bündig mit der Kartenoberseite (20) abschließt.

## Claims

1. A method for producing a portable data carrier with a display device, in particular a chip card with display, comprising the steps:
- providing a semifinished product with conductive paths (18) disposed in the interior,
- producing a recess (21) in the semifinished product,
- uncovering countercontact surfaces (26) of the conductive paths (18) in the recess (21),
- applying a reflection layer (23) onto the base surface (22) of the recess (21),
- inserting a display (1) into the recess (21), so that the display (1) together with the reflection layer (23) forms a reflective display, and
- contacting the countercontact surfaces (26) with contact surfaces (6) of the display (1).

2. The method according to claim 1, **characterized in that** the recess (21) is formed in a multi-step fashion, the countercontact surfaces (26) being uncovered on a step (25) of the multi-step recess (21) located above the base surface (22).

3. The method according to claim 1 or 2, **characterized in that** the contact surfaces (6) of the display (1) and the countercontact surfaces (26) of the recess (21) are contacted by means of an anisotropic electroconductive adhesive (13).

4. The method according to any of the claims 1 to 3, **characterized in that** the display (1) is inserted into the recess (21) in such a way that it is flush with a surface (20) of the semifinished product.

5. The method according to any of the claims 1 to 4, wherein gaps between the recess (21) and the display (1) inserted into the recess are sealed with a filling.

6. A portable data carrier with display device, in particular chip card with display, comprising a card body (19) with conductive paths (18) disposed in the interior of the card, a recess (21) located on a top side of the card (20), which accommodates a display (1), countercontact surfaces (26) in the recess (21), which are formed by the conductive paths (18) and which are contacted to contact surfaces (6) of the display (1), wherein the contact surfaces (6) of the display (1) are directed towards the base surface (22) of the recess (21), and a reflection layer (23) disposed between display (1) and base surface (22) of the recess (21), **characterized in that** the reflection layer (23) was applied onto the base surface (22) of the recess (21) before inserting the display (1) into the recess (21) and is firmly connected thereto.

7. The data carrier according to claim 6, **characterized in that** the recess (21) is formed in a multi-step fashion, wherein the countercontact surfaces (26) are formed on a step (25) of the multi-step recess (21) disposed between top side of the card (20) and base surface (22) and wherein the display (1) has a corresponding step with the contact surfaces (6) formed thereon.

8. The data carrier according to any of the claims 6 or 7, **characterized in that** the contact surfaces (6) and countercontact surfaces (26) are connected with an anisotropic electroconductive adhesive (13).

9. The data carrier according to any of the claims 6 to 8, **characterized in that** the display (1) is flush with the top side of the card (20).

## Revendications

1. Procédé de réalisation d'un support de données portable muni d'un dispositif d'affichage, en particulier une carte à puce avec un afficheur, comportant les étapes :
- préparation d'un demi-produit avec des pistes conductives (18), disposées à l'intérieur,
- réalisation d'un évidement (21) dans le demi-produit,
- mise à découvert des surfaces de contact complémentaires (26) des pistes conductives (18) dans l'évidement (21),
- application d'une couche de réflexion (23) sur le fond (22) de l'évidement (21),
- mise en place d'un afficheur (1) dans l'évidement (21), de telle sorte que l'afficheur (1), conjointement avec la couche de réflexion (23), forme un afficheur réfléchissant, et
- mise en contact des surfaces de contact complémentaires (26) avec des surfaces de contact (6) de l'afficheur (1).

2. Procédé selon la revendication 1, **caractérisé en ce que** l'évidement (21) est réalisé en plusieurs niveaux, les surfaces de contact complémentaires (26) étant mises à découvert sur un épaulement (25), disposé au-dessus du fond (22), de l'évidement (21) à plusieurs niveaux.

3. Procédé selon la revendication 1 ou 2, **caractérisé en ce que** les surfaces de contact (6) de l'afficheur (1) et les surfaces de contact complémentaires (26) de l'évidement (21) sont mises en contact au moyen d'une colle (13) électroconductrice anisotrope.

4. Procédé selon l'une quelconque des revendications 1 à 3, **caractérisé en ce que** l'afficheur (1) est inséré dans l'évidement (21), de telle sorte qu'il est situé à fleur d'une surface (20) du demi-produit.

5. Procédé selon l'une quelconque des revendications 1 à 4, dans lequel des fentes entre l'évidement (21) et l'afficheur (1), inséré dans l'évidement (21), sont scellées par un matériau de remplissage.

6. Support de données portable, muni d'un dispositif d'affichage, en particulier une carte à puce avec un afficheur, comportant un corps de carte (19) avec des pistes conductives (18), agencées à l'intérieur de la carte, un évidement (21), qui est situé sur une face supérieure (20) de la carte et qui reçoit un afficheur (1), des surfaces de contact complémentaires (26) dans l'évidement (21), qui sont formées par les pistes conductives (18) et qui sont mises en contact avec les surfaces de contact (6) de l'afficheur (1), les surfaces de contact (6) de l'afficheur (1) étant orientées vers le fond (22) de l'évidement (21), et une couche de réflexion (23) disposée entre l'afficheur (1) et le fond (22) de l'évidement (21), **caractérisé en ce que** la couche de réflexion (23) a été appliquée sur le fond (22) de l'évidement (21) avant la mise en place de l'afficheur (1) dans l'évidement (21) et est fermement liée avec ledit fond.

7. Support de données selon la revendication 6, **caractérisé en ce que** l'évidement (21) est réalisé en plusieurs niveaux, les surfaces de contact complémentaires (26) étant réalisées sur un épaulement (25), disposé entre une face supérieure (20) et un fond (22), de l'évidement (21) à plusieurs niveaux, et l'afficheur (1) comporte un épaulement correspondant sur lequel sont réalisées les surfaces de contact (6).

8. Support de données selon la revendication 6 ou 7, **caractérisé en ce que** les surfaces de contact (6) et les surfaces de contact complémentaires (26) sont reliées par une colle (13) électroconductrice anisotrope.

9. Support de données selon l'une quelconque des revendications 6 à 8, **caractérisé en ce que** l'afficheur (1) est situé à fleur de la face supérieure (20) de la carte.
